# EUROPÄISCHE PATENTSCHRIFT

(11) **EP 1 786 035 B1**
(45) Veröffentlichungstag und Bekanntmachung des Hinweises auf die Patenterteilung: **21.09.2011**
(21) Anmeldenummer: 06023024.0
(22) Anmeldetag: 06.11.2006
(51) Int. Cl.: H01L 25/16, H05K 1/14, H05K 7/20

(54) **Schaltungseinrichtung, insbesondere Frequenzumrichter**
Circuit arrangement, especially frequency converter
Agencement de circuit, notamment convertisseur de fréquence

(30) Priorität: 09.11.2005 DE 102005053396
(43) Veröffentlichungstag der Anmeldung: 16.05.2007
(73) Patentinhaber: Semikron Elektronik GmbH & Co. KG Patentabteilung, 90431 Nürnberg (DE)
(72) Erfinder: Göbl, Christian, 90441 Nürnberg (DE); Popp, Rainer, 91580 Petersaurach (DE)

(56) Entgegenhaltungen:
- EP-A2- 1 255 299
- WO-A1-94/13014
- DE-A1- 4 105 152
- DE-C1- 19 617 055
- DE-U1- 9 109 911
- US-A- 6 040 624
- US-A1- 2001 017 766

## Beschreibung

Die Erfindung betrifft eine Schaltungseinrichtung, insbesondere einen Frequenzumrichter, mit einem Schaltungsmodul, das mit einer Schaltungsplatine zusammengeschaltet und mit einem Kühlkörper verbunden ist.

Frequenzumrichter werden nach dem Stand der Technik mit TO's oder mit Leistungshalbleitermodulen aufgebaut. Dabei ist stets die Verschaltungsebene und die Kühlebene zu betrachten. Standardmodule sind stets so aufgebaut, dass die Verschaltungsebene und die Kühlebene zueinander parallel angeordnet sind. Infolge dieser Ausbildung mit Kühl- und Verschaltungsebene, die zueinander parallel angeordnet sind, sind Frequenzumrichter in einer sogenannten Anreihlösung nur bedingt realisierbar, weil sie zu breit bauen und demzufolge eine relativ große Schaltschrankbreite bedingen, die teuer erkauft werden muss. Werden solche Frequenzumrichter jedoch so gestaltet, dass sie als vergleichsweise schmale Anreihlösungen gestaltet sind, um den Einbauabmessungen von Schaltschützen, die durch Frequenzumrichter ersetzt werden, zu entsprechen, dann ist der Wärmefluss, das heißt die Wärmeableitung problematisch, weil diese um eine Ecke herum geleitet werden muss. Das bedeutet eine wenig effektive Kühlung.

Näheres zum Stand der Technik offenbart EP 1 255 299 A2 und zwar eine Schaltungseinrichtung mit einem Schaltungsmodul, das mit einer Schaltungsplatine zusammengeschaltet und mit einem Kühlkörper wärmeableitend verbunden ist, wobei das Schaltungsmodul eine flexible, elektrisch isolierende Kunststofffolie mit Metallkontakten aufweist, die mit einem Kontaktrand an einem Randabschnitt der Schaltungsplatine und mit Leistungshalbleiterchips kontaktiert ist, und am Kühlkörper ein Substrat befestigt ist, das mit einer Schaltungsstruktur zur Kontaktierung der Leistungshalbleiterchips ausgebildet ist.

In Kenntnis dieser Gegebenheiten liegt der Erfindung die Aufgabe zugrunde, eine Schaltungseinrichtung, insbesondere einen Frequenzumrichter, der eingangs genannten Art zu schaffen, der einfach aufgebaut eine optimale Kühlung ermöglicht.

Diese Aufgabe wird erfindungsgemäß durch die Merkmale des Anspruches 1, das heißt dadurch gelöst, dass das Schaltungsmodul eine flexible, elektrisch isolierende Kunststofffolie aufweist, die auf ihrer einen Seite eine dünne schaltstrukturierte Logikmetallschicht und auf der gegenüber liegenden zweiten Seite eine schaltstrukturierte Leistungsmetallschicht aufweist, die mit einem Kontaktrand an einem Randabschnitt der Schaltungsplatine kontaktiert ist, wobei das flexible Schaltungsmodul von der Platine abgewinkelt wegsteht, dass an der schaltstrukturierten Leistungsmetallschicht Leistungshalbleiterchips kontaktiert sind, und dass am Kühlkörper ein Substrat befestigt ist, das mit einer Schaltungsstruktur zur Kontaktierung der Leistungshalbleiterchips ausgebildet ist.

Die Erfindung weist den Vorteil auf, dass das flexible Schaltungsmodul an dafür vorgesehenen Stellen biegbar ist. Das bedeutet, dass die Kühlebene und die Verschaltungsebene miteinander einen beliebigen Winkel einschließen können. Ein ganz wesentlicher Vorteil der Erfindung besteht darin, dass das Schaltungsmodul mit seinen an der schaltstrukturierten Leistungsmetallschicht kontaktierten Leistungshalbleiterchips und die Schaltungsplatine in einer gemeinsamen Ebene in einer bekannten Technologie, wie zum Beispiel einer Löt- oder Schweiß-Technologie miteinander verbunden werden können. Danach können diese beiden Komponenten in Bezug zueinander in jede beliebige, das heißt in eine vorgegebene Winkelposition verschwenkt werden. Dadurch ist es möglich, Frequenzumrichter relativ klein zu bauen, wobei diese kleinere Dimensionierung, die sich optimal für Anreihlösungen eignet, mit einer wirksamen Kühlung des Frequenzumrichters einher geht.

Erfindungsgemäß besitzt das flexible Schaltungsmodul im Vergleich zur Schaltungsplatine kleine Flächenabmessungen. Das flexible Schaltungsmodul kann mit der Schaltungsplatine zum Beispiel einen Winkel von 90° einschließen.

Das Substrat weist vorzugsweise Flächenabmessungen auf, die an die Flächenabmessungen des flexiblen Schaltungsmoduls angepasst sind.

Der Kühlkörper kann ein abgewinkeltes Metallblech mit einem ersten und einem zweiten Blechabschnitt aufweisen, wobei am ersten Blechabschnitt das Substrat fixiert ist, und wobei der zweite Blechabschnitt an die Schaltungsplatine angepasste Flächenabmessungen aufweisen kann. Am ersten Blechabschnitt kann ein Kühlelement fixiert sein. Dieses Kühlelement kann beispielsweise mit Kühlrippen ausgebildet sein.

Weitere Einzelheiten, Merkmale und Vorteile ergeben sich aus der nachfolgenden Beschreibung eines in der Zeichnung dargestellten Ausführungsbeispieles der erfindungsgemäßen Schaltungseinrichtung, insbesondere Frequenzumrichter, im Vergleich mit einem Frequenzumrichter nach dem Stand der Technik - in Anreihlösung.
- Fig. 1: verdeutlicht in einer Vorderansicht schematisch und nicht maßstabgetreu eine erfindungsgemäße Ausbildung der Schaltungseinrichtung, insbesondere Frequenzumrichter in Anreihlösung, und
- Fig. 2: verdeutlicht in einer der Fig. 1 ähnlichen Ansicht schematisch und nicht maßstabgetreu einen bekannten Frequenzumrichter in Anreihlösung.

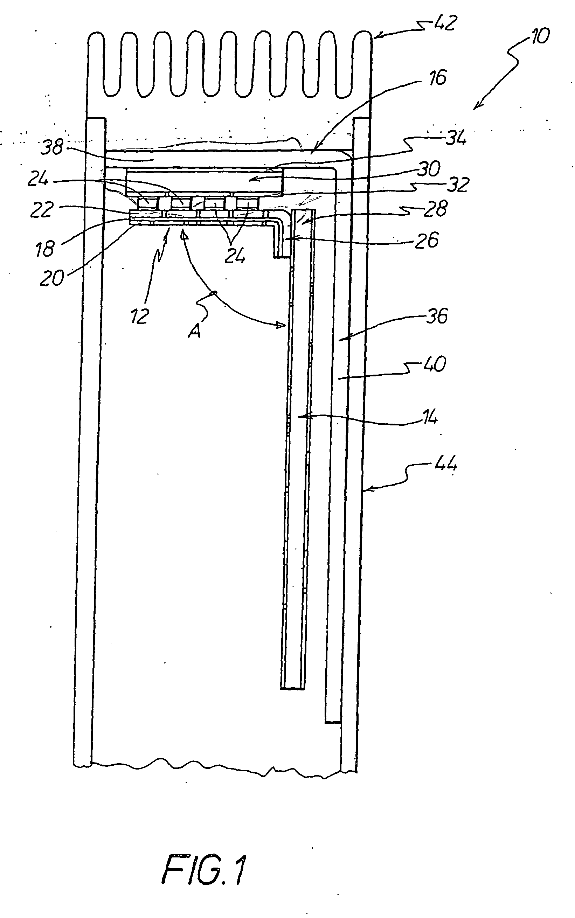

Fig. 1 zeigt schematisch eine Ausbildung der erfindungsgemäßen Schaltungseinrichtung, insbesondere Frequenzumrichter 10, mit einem Schaltungsmodul 12, das mit einer Schaltungsplatine 14 zusammengeschaltet und mit einem Kühlkörper 16 wärmeableitend verbunden ist.

Das Schaltungsmodul 12 weist eine flexible, elektrisch isolierende Kunststofffolie 18 auf, die auf ihrer einen Seite eine dünne schaltstrukturierte Logikmetallschicht 20 und auf der gegenüberliegenden zweiten Seite eine schaltstrukturierte Leistungsmetallschicht 22 aufweist. An der Leistungsmetallschicht 22 sind Leistungshalbleiterchips 24 kontaktiert.

Die schaltstrukturierte Leistungsmetallschicht 22 ist mit einem Kontaktrand 26 an einem Randabschnitt 28 der Schaltungsplatine 14 kontaktiert. Hierbei werden Leistungs- und/oder Hilfskontakte verbunden. Diese Kontaktierung erfolgt durch Löten oder Schweißen in einem Ausgangszustand des Schaltungsmoduls 12, bei dem das Schaltungsmodul 12 und die Schaltungsplatine 14 gleichsam in einer gemeinsamen Ebene positioniert sind. Nach der Kontaktierung wird das Schaltungsmodul 12 von der Ebene der Schaltungsplatine 14 weggebogen, so dass das Schaltungsmodul 12 mit der Schaltungsplatine 14 einen Winkel A einschließt. Dieser Winkel A beträgt zum Beispiel 90°.

Am Kühlkörper 16 ist ein Substrat 30 befestigt, das auf seiner einen Seite mit einer Schaltungsstruktur 32 zur Kontaktierung der Leistungshalbleiterchips 24 ausgebildet ist. Die gegenüber liegende zweite Seite des Substrates 30 weist eine Metallschicht 34 auf, mit der das Substrat 30 gut wärmeleitend am Kühlkörper 16 befestigt ist.

Der Kühlkörper 16 ist von einem abgewinkelten Metallblech 36 gebildet, das einen ersten Blechabschnitt 38 und einen zweiten Blechabschnitt 40 aufweist. Am ersten Blechabschnitt 38 ist das Substrat 30 fixiert. Der zweite Blechabschnitt 40 weist Flächenabmessungen auf, die an die Flächenabmessungen der Schaltungsplatine 14 angepasst sind. Am ersten Blechabschnitt 38 ist ein Kühlelement 42 wärmeleitend befestigt, das mit Kühlrippen ausgebildet ist.

Mit der Bezugsziffer 44 ist ein Gehäuse des Frequenzumrichters 10 bezeichnet, das abschnittweise angedeutet ist. Der erfindungsgemäße Frequenzumrichter 10 weist solche Außenabmessungen auf, dass er sich optimal für eine sogenannte Anreihlösung eignet.

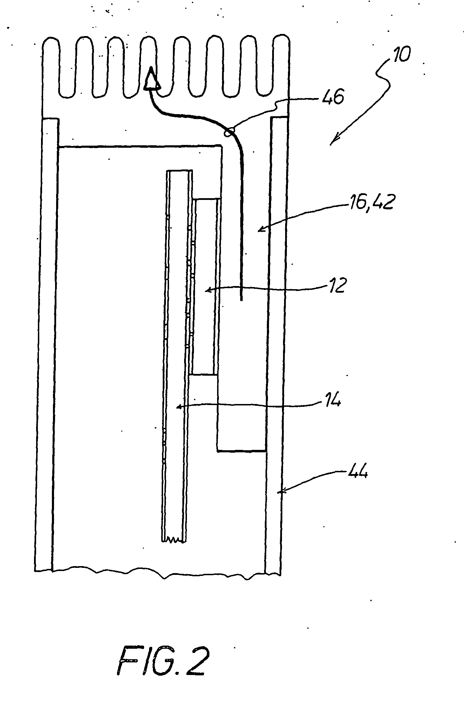

Fig. 2 verdeutlicht in einer der Fig. 1 ähnlichen Ansicht eine bekannte Ausbildung eines Frequenzumrichters 10 in einer Anreihlösung, wobei gleiche Einzelheiten mit denselben Bezugsziffern wie in Fig. 1 bezeichnet sind, so dass es sich erübrigt, in Verbindung mit Fig. 2 alle diese Einzelheiten noch einmal detailliert zu beschreiben. Die Fig. 2 soll insbesondere den unzureichenden, abgewinkelten Wärmefluss, das heißt die Wärmeableitung vom Schaltungsmodul 12 verdeutlichen. Diese abgewinkelte Wärmeableitung ist durch den Pfeil 46 angedeutet.

### Bezugsziffernliste:

- 10: Frequenzumrichter
- 12: Schaltungsmodul (von 10)
- 14: Schaltungsplatine (von 10)
- 16: Kühlkörper (von 10 für 12)
- 18: Kunststoffolie (von 12)
- 20: strukturierte Logikmetallschicht (an 18)
- 22: strukturierte Leistungsmetallschicht (an 18)
- 24: Leistungshalbleiterchips (an 22)
- 26: Kontaktrand (von 22)
- 28: Randabschnitt (von 14)
- 30: Substrat (für 24 an 16)
- 32: Schaltungsstruktur (an 30 für 24)
- 34: Metallschicht (an 30 für 16)
- 36: Metallblech (von 16)
- 38: erster Blechabschnitt (von 36)
- 40: zweiter Blechabschnitt (von 36)
- 42: Kühlelement (an 38)
- 44: Gehäuse (von 10)
- 46: Pfeil/Wärmeableitung/Wärmefluss

## Patentansprüche

1. Schaltungseinrichtung mit einem Schaltungsmodul (12), das mit einer Schaltungsplatine (14) zusammengeschaltet und mit einem Kühlkörper (16) wärmeableitend verbunden ist, wobei
das Schaltungsmodul (12) ein Substrat (30), Leistungshalbleiterchips (24) und eine flexible, elektrisch isolierende Kunststofffolie (18) aufweist, die auf ihrer einen Seite eine dünne schaltstrukturierte Logikmetallschicht (20) und auf der gegenüber liegenden Seite eine schaltstrukturierte Leistungsmetallschicht (22) aufweist, die mit einem Kontaktrand (26) an einem Randabschnitt (28) der Schaltungsplatine (14) kontaktiert ist,
das Schaltungsmodul (12) von der Schaltungsplatine (14) abgewinkelt wegsteht,
an der schaltstrukturierten Leistungsmetallschicht (22) die Leistungshalbleiterchips (24) kontaktiert sind, und
am Kühlkörper (16) das Substrat (30) befestigt ist, das mit einer Schaltungsstruktur (32) zur Kontaktierung der Leistungshalbleiterchips (24) ausgebildet ist.

2. Schaltungseinrichtung nach Anspruch 1, wobei das Schaltungsmodul (12) im Vergleich zur Schaltungsplatine (14) kleine Flächenabmessungen besitzt.

3. Schaltungseinrichtung nach Anspruch 1, wobei das Schaltungsmodul (12) mit der Schaltungsplatine (14) einen Winkel von 90° einschließt.

4. Schaltungseinrichtung nach Anspruch 1, wobei das Substrat (30) Flächenabmessungen aufweist, die an die Flächenabmessungen des Schaltungsmoduls (12) angepasst sind.

5. Schaltungseinrichtung nach Anspruch 1, wobei der Kühlkörper (16) ein abgewinkeltes Metallblech (36) mit einem ersten und einem zweiten Blechabschnitt (38 und 40) aufweist, wobei am ersten Blechabschnitt (38) das Substrat (30) fixiert ist, und wobei der zweite Blechabschnitt (40) an die Schaltungsplatine (14) angepasste Flächenabmessungen aufweist.

6. Schaltungseinrichtung nach Anspruch 5, wobei am ersten Blechabschnitt (38) ein Kühlelement (42) befestigt ist.

7. Schaltungseinrichtung nach einem der vorhergehenden Ansprüche, wobei die Schaltungseinrichtung ein Frequenzumrichter (10) ist.

## Claims

1. A circuit device with a circuit module (12), which is interconnected with a circuit board (14), and is connected with a cooling body (16) such that heat can be removed, wherein
the circuit module (12) has a substrate (30), power semiconductor chips (24) and a flexible, electrically insulating plastic film (18), which on its one side has a thin metal layer with a logic circuit structure (20), and on the opposing side a metal layer with a power circuit structure (22), which is in contact with a contact edge (26) on an edge section (28) of the circuit board (14),
the circuit module (12) projects from the circuit board (14) at an angle,
power semiconductor chips (24) are in contact with the power circuit structure metal layer (22), and
the substrate (30) is attached to the cooling body (16), which substrate is designed with a circuit structure (32) for the purpose of making contact with the power semiconductor chips (24).

2. The circuit device in accordance with claim 1, wherein
the circuit module (12) possesses small surface dimensions in comparison with the circuit board (14).

3. The circuit device in accordance with claim 1, wherein
the circuit module (12) subtends an angle of 90° with the circuit board (14).

4. The circuit device in accordance with claim 1, wherein
the substrate (30) has surface dimensions that are matched to the surface dimensions of the circuit module (12).

5. The circuit device in accordance with claim 1, wherein
the cooling body (16) has an angled metal plate (36), with a first and a second plate section (38 and 40), wherein
the substrate (30) is fixed to the first plate section (38), and wherein
the second plate section (40) has surface dimensions matched to the circuit board (14).

6. The circuit device in accordance with claim 5, wherein
a cooling element (42) is attached to the first plate section (38).

7. The circuit device in accordance with one of the preceding claims, wherein
the circuit device is a frequency converter (10).

## Revendications

1. Dispositif de circuit comprenant un module de circuit (12), qui est interconnecté avec une platine de circuit (14) et est relié à un corps réfrigérant (16) de façon à dissiper la chaleur,
le module de circuit (12) présentant un substrat (30), des puces à semi-conducteurs de puissance (24) et un film plastique (18) flexible électro-isolant, qui présente sur l'un de ses côtés une couche métallique de logique (20) mince et structurée au niveau de la commutation et sur le côté opposé une couche métallique de puissance (22) structurée au niveau de la commutation, qui est mis en contact avec un bord de contact (26) sur une partie de bordure (28) de la platine de circuit (14),
le module de circuit (12) dépassant de façon coudée de la platine de circuit (14),
les puces à semi-conducteurs de puissance (24) étant mises en contact sur la couche métallique de puissance (22) structurée au niveau de la commutation, et
le substrat (30), qui est conçu avec une structure de circuit (32) pour la mise en contact avec les puces à semi-conducteurs de puissance (24), étant fixé sur le corps réfrigérant (16).

2. Dispositif de circuit selon la revendication 1, le module de circuit (12) présentant de petites dimensions de surface par rapport à la platine de circuit (14).

3. Dispositif de circuit selon la revendication 1, le module de circuit (12) formant un angle de 90° avec la platine de circuit (14).

4. Dispositif de circuit selon la revendication 1, le substrat (30) présentant des dimensions de surface, qui sont adaptées aux dimensions de surface du module de circuit (12).

5. Dispositif de circuit selon la revendication 1, le corps réfrigérant (16) présentant une tôle métallique (36) coudée avec une première et une seconde partie de tôle (38 et 40), le substrat (30) étant fixé sur la première partie de tôle (38), et la seconde partie de tôle (40) présentant des dimensions de surface adaptées à la platine de circuit (14).

6. Dispositif de circuit selon la revendication 5, un élément réfrigérant (42) étant fixé sur la première partie de tôle (38).

7. Dispositif de circuit selon l'une quelconque des revendications précédentes, le dispositif de circuit étant un convertisseur de fréquence (10).
